# EUROPEAN PATENT SPECIFICATION

(11) **EP 4 386 830 B1**
(45) Date of publication and mention of the grant of the patent: **25.11.2026**
(21) Application number: 23201726.9
(22) Date of filing: 05.10.2023
(51) Int. Cl.: H10W 20/49, H10W 40/10

(54) **FUSE STRUCTURE WITH METAL HEATER AND HEAT SPREADING STRUCTURE FOR FUSE BODY**
SICHERUNGSSTRUKTUR MIT METALLISCHEM HEIZER UND WÄRMEVERTEILUNGSSTRUKTUR FÜR SICHERUNGSKÖRPER
STRUCTURE DE FUSIBLE AVEC ÉLÉMENT CHAUFFANT MÉTALLIQUE ET STRUCTURE DE DISSIPATION DE CHALEUR POUR CORPS DE FUSIBLE

(30) Priority: 12.12.2022 US 202218064472
(43) Date of publication of application: 19.06.2024
(60) Divisional application: 26197789.6 / 4 815 711
(73) Proprietor: GlobalFoundries U.S. Inc., Malta, NY 12020 (US)
(72) Inventor: Pandey, Shesh Mani, Malta, 12020 (US); Levy, Mark D., Essex Junction, 05452 (US); Tan, Chung Foong, Malta, 12020 (US)
(74) Representative: Grünecker Patent- und Rechtsanwälte PartG mbB

(56) References cited:
- CN-A- 104 659 013
- CN-A- 109 148 414
- US-A1- 2005 029 620
- US-A1- 2007 221 966

## Description

### BACKGROUND

The present disclosure relates to fuses, and more specifically, to a fuse structure including a polysilicon fuse body with a metal heater and a heat spreading structure.

Different parts of an integrated circuit (IC) may be coupled using an electrical fuse (e-fuse). E-fuses can be 'programmed' to change interconnections within the IC. More particularly, a fuse body or link can be caused to stop or greatly reduce current flow therethrough by application of a prescribed current controlled, for example, by a transistor. Once sufficient changes have occurred in the fuse body, the fuse body is open or blown, stopping or greatly reducing current from passing through the fuse. One common fuse includes a fuse body made of polysilicon. One challenge presented by polysilicon e-fuses is that they occupy a large footprint in ICs due to the size of the fuse body and the associated current source needed to program them. Polysilicon e-fuses can be heated to reduce the amount of current required to program them. However, current heating approaches are ineffective at delivering sufficient heat to reduce the current required to program the fuse.

Document CN 104 659 013 A discloses an electric fuse structure which comprises a substrate, an electric fuse on the substrate, and a heating structure on the substrate. The electric fuse comprises a fuse, an anode, and a cathode which are respectively located at both ends of the fuse and connected to the fuse. A heating structure on the substrate that is electrically isolated from the electrical fuse by a dielectric layer for transferring the generated heat to the electrical fuse.

### SUMMARY

An aspect of the invention provides a fuse structure in accordance with independent claim 1, advantageous embodiments being defined in dependent claims 2 to 12.

Another aspect of the invention provides a method in accordance with independent claim 13.

Two or more aspects described in this disclosure, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The embodiments of this disclosure will be described in detail, with reference to the following figures, wherein like designations denote like elements, and wherein:
FIG. 1 shows a perspective view of a fuse structure, according to embodiments of the disclosure;
FIG. 2 shows a Y cross-sectional view of the fuse structure of FIG. 1 along view line 2-2;
FIG. 3 shows an X cross-sectional view of the fuse structure of FIG. 1 along view line 3-3;
FIG. 4 shows a Y cross-sectional view of a fuse structure, according to other embodiments of the disclosure;
FIG. 5 shows an X cross-sectional view of a fuse structure, according to other embodiments of the disclosure;
FIG. 6 shows a Y cross-sectional view of a fuse structure, according to another embodiment of the disclosure;
FIG. 7A shows a Y cross-sectional view of a fuse structure, according to another embodiment of the disclosure;
FIG. 7B shows a Y cross-sectional view of a fuse structure showing alternative arrangements of metal contacts of a heat spreading structure, according to another embodiment of the disclosure;
FIG. 8 shows a top-down view of a fuse structure, according to other embodiments of the disclosure;
FIG. 9 shows a top-down view of a fuse structure, according to yet other embodiments of the disclosure;
FIG. 10 shows a top-down view of a fuse structure, according to other embodiments of the disclosure;
FIG. 11 shows a top-down view of a fuse structure, according to yet other embodiments of the disclosure;
FIG. 12 shows a Y cross-sectional view of a fuse structure, according to an embodiment not covered by the claims;
FIG. 13 shows a Y cross-sectional view of a fuse structure, according to another embodiment not covered by the claims;
FIG. 14 shows a Y cross-sectional view of a fuse structure, according to yet another embodiment not covered by the claims;
FIG. 15 shows a Y cross-sectional view of a fuse structure, according to another embodiment of the disclosure; and
FIG. 16 shows a Y cross-sectional view of a fuse structure, according to yet another embodiment of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (A) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

Embodiments of the disclosure include a fuse structure having a fuse body including a polysilicon, and a metal heater over the fuse body. The fuse structure also includes a heat spreading structure thermally coupled to the metal heater and extending horizontally adjacent to at least one side of the fuse body. The metal heater can be a portion of a metal wire or a resistor including a resistive metal. The heat spreading structure may include a plurality of metal contacts. The fuse structure including the heat spreading structure reduces the necessary programming energy and also reduces the size of a programming current source, which will reduce the overall circuitry footprint. The fuse structure does not require any additional masks to implement.

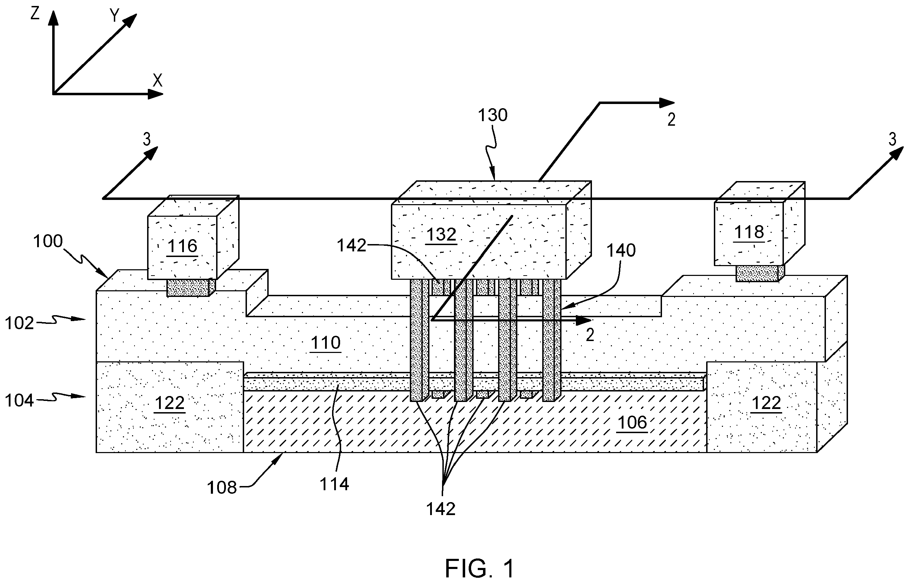

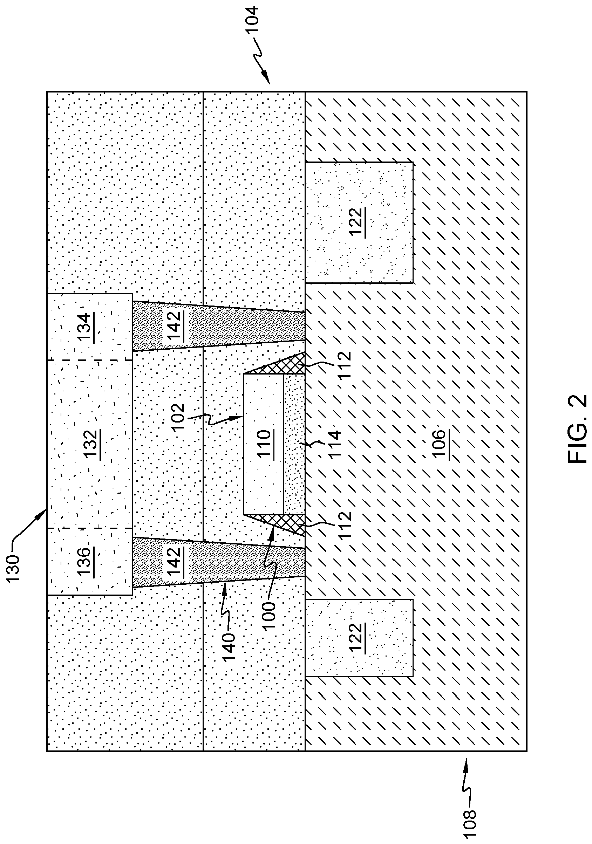

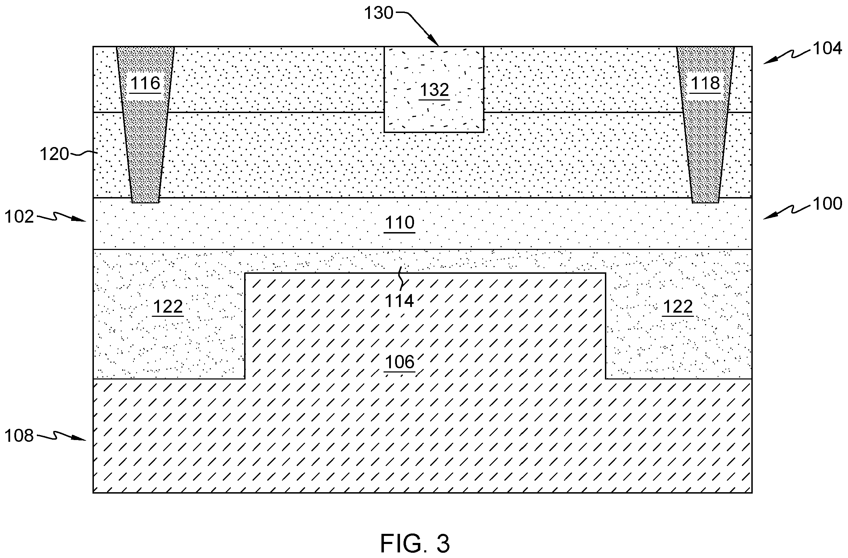

FIG. 1 shows a perspective view of a fuse structure 100 according to embodiments of the disclosure. FIG. 2 shows a Y cross-sectional view of fuse structure 100 in FIG. 1 along view line 2-2 (across fuse body 102), and FIG. 3 shows an X cross-sectional view of fuse structure 100 in FIG. 1 along view line 3-3 (through fuse body 102).

Fuse structure 100 includes a fuse body 102 including a polysilicon. The polysilicon can be any polysilicon used for fuses and/or during formation of other devices such as transistor or resistors (not shown) over an active region 106 of an integrated circuit (IC) structure 104. That is, fuse body 102 may be formed as part of active region 106 of a substrate 108 in IC structure 104 in which fuse structure 100 is used. For purposes of description, substrate 108 is shown as a bulk semiconductor substrate, but it may include any now known or later developed substrate, e.g., fin, nanosheets, semiconductor-on-insulator (SOI). Fuse body 102 may include a polysilicon body 110. Polysilicon body 110 may have a pair of spacers 112 (FIG. 2 only) on opposing sides thereof. Spacers 112 may include any now known or later developed spacer material such as but not limited to silicon nitride. Spacers 112 may be omitted in some cases. Fuse body 102 is on a dielectric layer 114. Dielectric layer 114 may include any now known or later developed gate dielectric materials such as but not limited to hafnium silicate (HfSiO), hafnium oxide (HfO₂), zirconium silicate (ZrSiOₓ), zirconium oxide(ZrO₂), silicon oxide (SiO₂), silicon nitride (Si₃N₄), silicon oxynitride (SiON), high-k material or any combination of these materials.

As shown in FIGS. 1 and 3, fuse structure 100 may include a first fuse electrode 116 and a second fuse electrode 118 coupled to respective opposite ends of fuse body 102. Fuse electrodes 116, 118 may include any form of metal contacts and/or wires extending through interlayer dielectric (ILD) layer(s) 120 (FIG. 3) above fuse body 102. Active region 106 and fuse structure 100 may be further electrically isolated by any variety of trench isolations 122, e.g., trenches filled with silicon oxide.

Fuse structure 100 also includes a metal heater 130 over fuse body 102. As shown in FIG. 1, metal heater 130 (laterally) overlaps at least a portion of fuse body 102 such that heat produced by metal heater 130 heats fuse body 102. A dielectric layer (portion of ILD layer(s) 120) is between fuse body 102 and particularly, polysilicon body 110 thereof and metal heater 130. As will be described, metal heater 130 can take a variety of forms according to embodiments of the disclosure.

In FIGS. 1-3, metal heater 130 includes at least a portion of a metal wire 132. Metal wire 132 can be any now known or later developed wire structure found in IC structure 104. Metal wire 132 and any metal contacts (described herein) can be formed using any now known or later developed semiconductor fabrication techniques. In one non-limiting example, metal wires and metal contacts may be formed by patterning a mask, etching wire and/or contact openings in respective dielectric layer(s). The metal may include refractory metal liner and a metal body. The refractory metal liner (not shown for clarity) may include, for example, ruthenium (Ru), tantalum (Ta), titanium (Ti), tungsten (W), iridium (Ir), rhodium (Rh) and platinum (Pt), etc., or mixtures of thereof. The metal body may be any now known or later developed contact or wire metal such as but not limited to copper (Cu) or tungsten (W). Metal wires 132 may run laterally in any manner required to route electrical signals.

Metal heater 130 also includes a first heater electrode 134 and a second heater electrode 136 coupled to respective opposite ends of metal heater 130 and defining an electrical current path through metal wire 132 of metal heater 130. In FIG. 2, electrodes 134, 136 are shown (dashed lines) as portions of metal wire 132, but could also include metal contacts to the opposite ends of metal heater 130.

Fuse structure 100 also includes a heat spreading structure 140 thermally coupled to metal heater 130 and extending horizontally adjacent to at least one side of fuse body 102. In FIGS. 1-3, heat spreading structure 140 includes a plurality of metal contacts 142. Metal contacts 142 in IC structure 104 can take a couple of forms. Certain metal contacts, such as those used as electrodes 116, 118 for fuse body 102, are operative metal contacts and carry electrical signals/current. Metal contacts 142 that are part of heat spreading structure 140 have the same physical structure as operative metal contacts, but in certain embodiments, may be used solely for communication of heat (thermal communication) from metal heater 130 to fuse body 102 and do not necessarily carry an electrical signal/current. Hence, operative metal contacts such as electrodes 116, 118 may run vertically in any manner required to route electrical signals. Similarly, metal contacts 142 of heat spreading structure 140 may run vertically in any manner to mainly direct heat to fuse body 102. As will be described, in some cases metal contacts 142 may transmit heat and carry current.

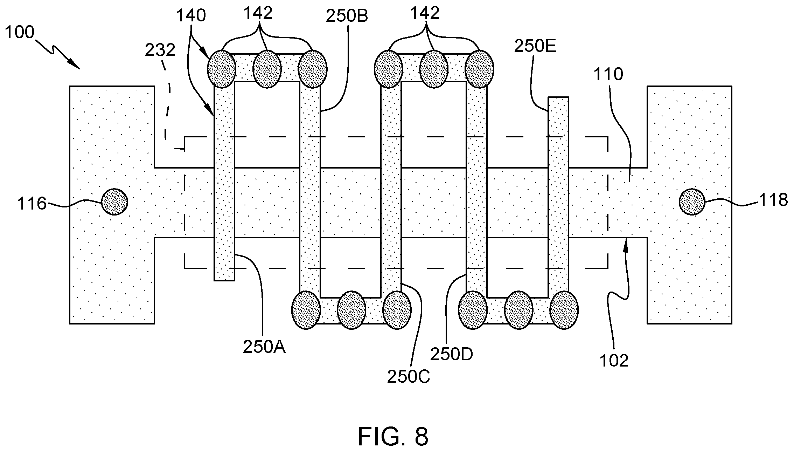

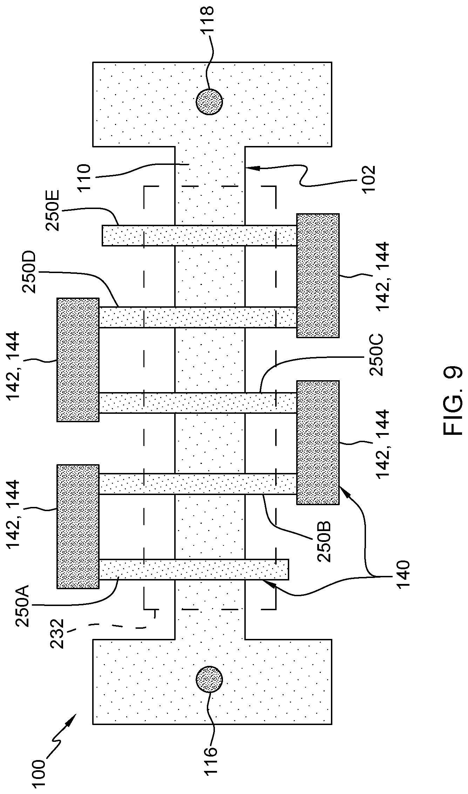

As shown in FIGS. 1 and 2, heat spreading structure 140, e.g., metal contacts 142, extend vertically to be horizontally adjacent to pair of spacers 112 of fuse body 102. Metal contacts 142 do not land on fuse body 102, and may partially land on spacers 112 or land on active region 106 adjacent to fuse body 102. According to the invention, metal contacts 142 of heat spreading structure 140 are outside the electrical current path of metal heater 130, i.e., there is no current running through metal contacts 142. Heat from metal heater 130 is delivered by heat spreading structure 140 closer to fuse body 102 than in conventional fuse structures, reducing the necessary programming energy necessary for fuse structure 100. Fuse structure 100 with heat spreading structure 140 also reduces the size of a required programming current source, which reduces the overall circuitry footprint. Also, advantageously, fuse structure 100 does not require any additional masks to implement - metal contacts 142 can be formed at the same time as other operative metal contacts (e.g., electrodes 116, 118 of fuse body 102) of IC structure 104. Metal contacts 142 can have any cross-sectional shape typically used within IC structures such as circular (see e.g., FIG. 8) or bar shaped (see e.g., FIG. 9). In the latter case, metal contacts 142 may become elongated elements 144 (FIG. 9) running parallel to fuse body 102. Metal contacts 142 may also have a cross-sectional dimension configured to create the desired heating of fuse body 102. Further, any number of metal contacts 142 may be used to create the desired heating of fuse body 102. While metal contacts 142 are shown on both sides of fuse body 102, they may be used only on one side.

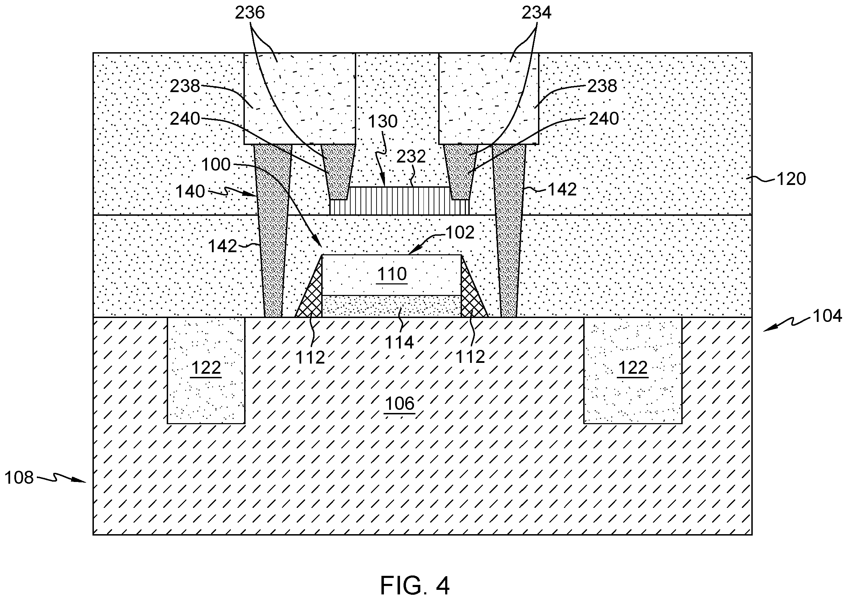

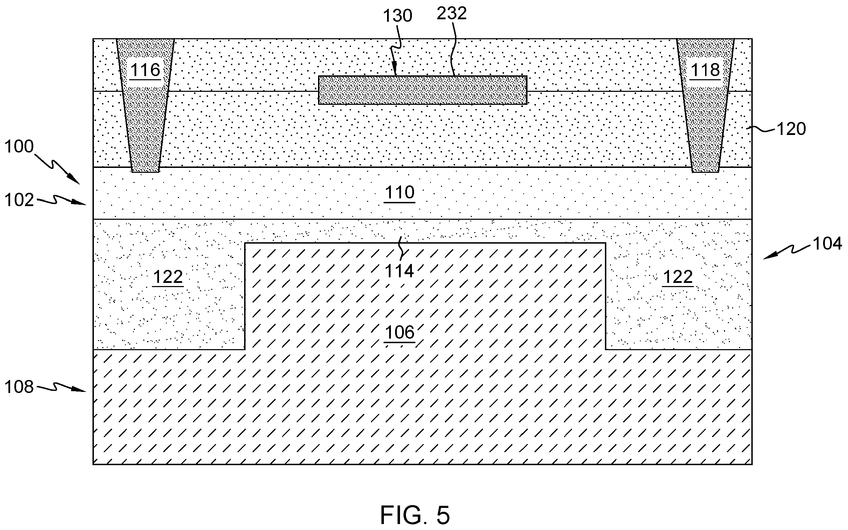

FIG. 4 shows a Y cross-sectional view of fuse structure 100 (similar to FIG. 2), and FIG. 5 shows an X cross-sectional view of fuse structure 100 (similar to FIG. 3), according to another embodiment of the disclosure. In this embodiment, fuse structure 100 includes metal heater 130 in the form of a resistor 232 including a resistive metal. The resistive metal may include any now known or later developed metal or metal alloy used for a resistor element such as but not limited to: titanium, tantalum nitride, tungsten silicide or tungsten polysilicon. As in FIGS. 1-3, heat spreading structure 140 may include plurality of metal contacts 142 in thermal contact with metal heater 130, but here the metal heater includes resistor 232. Heat spreading structure 140, e.g., metal contacts 142, extend vertically to be horizontally adjacent to fuse body 102, e.g., pair of spacers 112 of fuse body 102. Metal contacts 142 do not land on fuse body 102, and may partially land on spacers 112 or land on active region 106 adjacent to fuse body 102.

Metal heater 130 in the form of resistor 232 may include a first heater electrode 234 and a second heater electrode 236 coupled to respective opposite ends of resistor 232, and defining an electrical current path through resistor 232. In FIG. 4, electrodes 234, 236 are shown as metal wires 238 with contacts 240 thereunder, however, they could take other forms. While the contacts for electrodes 234, 236 are shown as separate from metal contacts 142, they may be one structure, e.g., with metal contacts 142 partially landing on resistor 232 and partially extending vertically to be horizontally adjacent to pair of spacers 112 of fuse body 102.

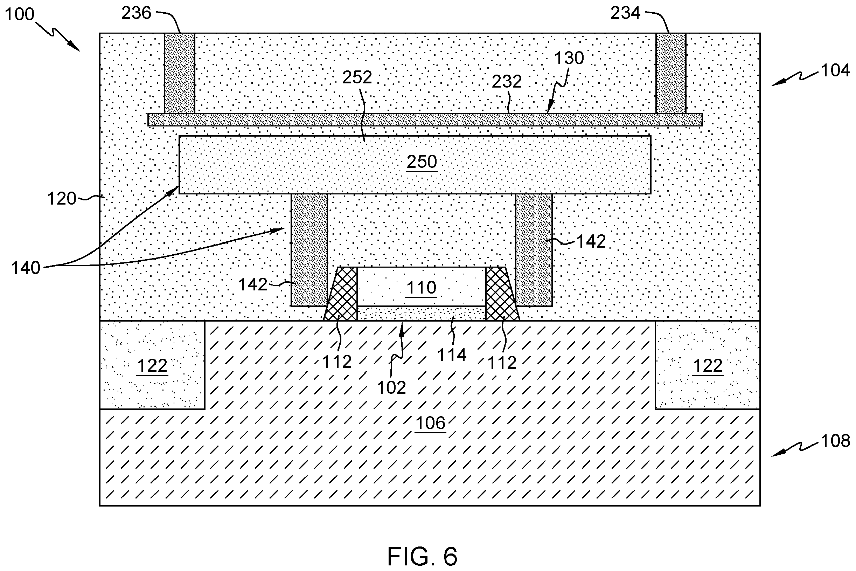

FIG. 6 shows a Y cross-sectional view of fuse structure 100 (similar to FIGS. 2 and 4), according to another embodiment of the disclosure. In this embodiment, metal heater 130 includes resistor 232 with first heater electrode 234 and second heater electrode 236 extending vertically thereabove. As in FIGS. 4-5, heat spreading structure 140 may include plurality of metal contacts 142 in thermal contact with resistor 232. Heat spreading structure 140, e.g., metal contacts 142, extend vertically to be horizontally adjacent to fuse body 102, e.g., pair of spacers 112 of fuse body 102. Metal contacts 142 do not land on fuse body 102, and may partially land on spacers 112 or land on active region 106 adjacent to fuse body 102. However, in this embodiment, metal contacts 142 are not directly coupled to resistor 232. In contrast, heat spreading structure 140 also includes a metal wire 250 thermally coupling metal contacts 142 together. In FIG. 6, resistor 232 is over metal wire 250. A thin dielectric layer 252 (part of ILD layer(s) 120) may separate resistor 232 and metal wire 250. In this manner, resistor 232 heats metal wire 250 and the heat is transferred laterally over fuse body 102 and then vertically thereto by metal contacts 142.

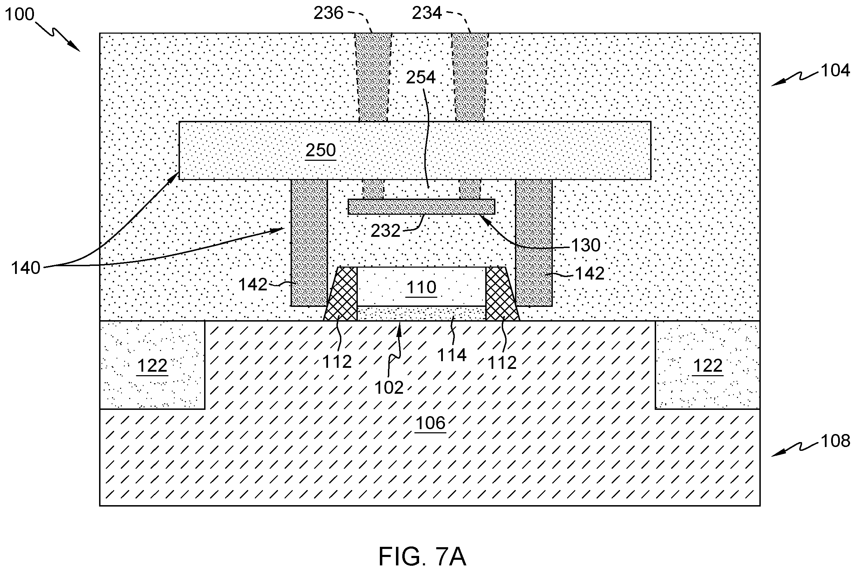

FIG. 7A shows a Y cross-sectional view of fuse structure 100, according to another embodiment of the disclosure. FIG. 7A is similar to FIG. 6, except resistor 232 is between metal wire 250 and fuse body 102, i.e., metal wire 250 is above resistor 232. Heater electrodes 234, 236 are routed to avoid metal wire 250, i.e., to the sides of metal wire 250, and metal contacts 142 of heat spreading structure 140 are routed to avoid resistor 232, i.e., to the sides of resistor 232. A thin dielectric layer 254 (part of ILD layer(s) 120) may separate resistor 232 and metal wire 250. Here, again, resistor 232 heats metal wire 250 and the heat is transferred laterally over fuse body 102 and then vertically thereto by metal contacts 142.

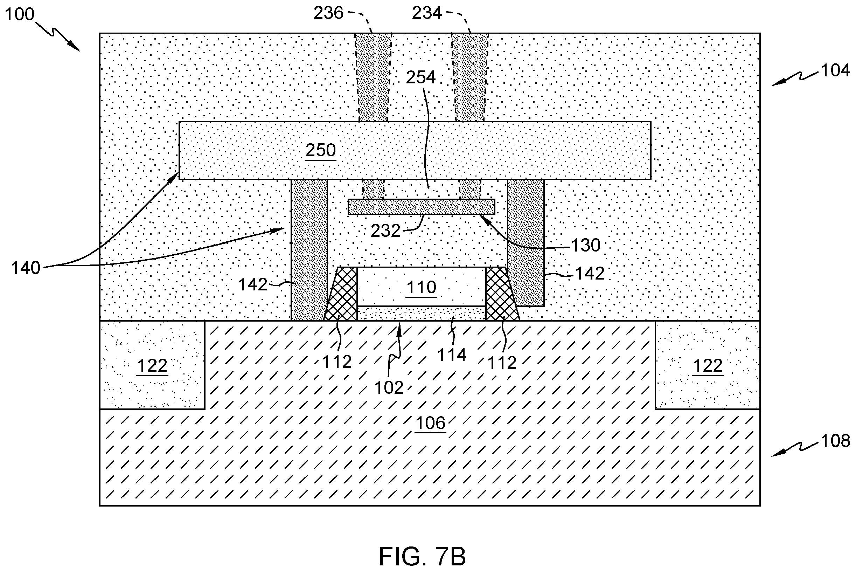

FIG. 7B shows a Y cross-sectional view of fuse structure 100 showing various landing arrangements of metal contacts 142 of heat spreading structure 140, according to alternative embodiments of the disclosure. While shown with the FIG. 7A embodiment, the various alternative embodiments of metal contacts 142 can be applied to any embodiment disclosed herein. In FIGS. 6 and 7A, metal contacts 142 of fuse structure 100 do not land on any structure, but simply pass next to spacers 112. In one alternative arrangement, shown on the left side of FIG. 7B, metal contacts 142 may land on active region 106, i.e., they contact and stop on active region 106. (See also FIGS. 2, 4 and 12-16). In another alternative arrangement, shown on the right side of FIG. 7B, metal contacts 142 may at least partially land on spacer 112, e.g., depending on a width of spacer 112. While each drawing shows a particular landing arrangement for metal contacts 142, metal contacts 142 within a given heat spreading structure 140 and/or fuse structure 100 may include any landing arrangement. That is, metal contacts 142 within given heat spreading structure 140 and/or fuse structure 100 can have different landing arrangements.

FIGS. 8 and 9 show top-down views of fuse structure 100 according to another embodiment. FIGS. 8 and 9 are similar to FIGS. 6 and 7, but in this embodiment, metal wire 250 of heat spreading structure 140 includes a plurality of metal wires 250A-E extending over fuse body 102. Each metal wire 250A-E may couple to at least a portion of the plurality of metal contacts 142, e.g., one or more of the metal contacts 142. In FIGS. 8 and 9, metal heater 130 may include resistor 232 (shown in dashed lines to indicate it can be above or below metal wires 250A-E). While five metal wires 250A-E are shown arranged in a sinusoidal layout, any number of metal wires 250 may be used and may be coupled to any number of metal contacts 142 to provide the desired heat transfer to fuse body 102.

FIGS. 8 and 9 also show a couple of the cross-sectional shape options, among others, of metal contacts 142. FIG. 8 shows a circular cross-section, and FIG. 9 shows a bar shaped cross-section. As shown in FIG. 9, metal contacts 142 may become elongated elements 144 running parallel to fuse body 102. As noted, metal contacts 142 may also have a cross-sectional dimension configured to create the desired heating of fuse body 102. Further, any number of metal contacts 142 may be used to create the desired heating of fuse body 102. Again, while metal contacts 142 are shown on both sides of fuse body 102, they may be used only on one side.

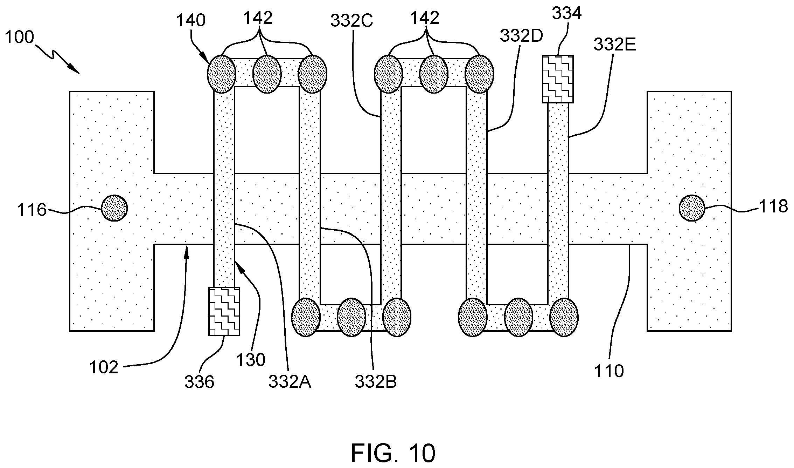

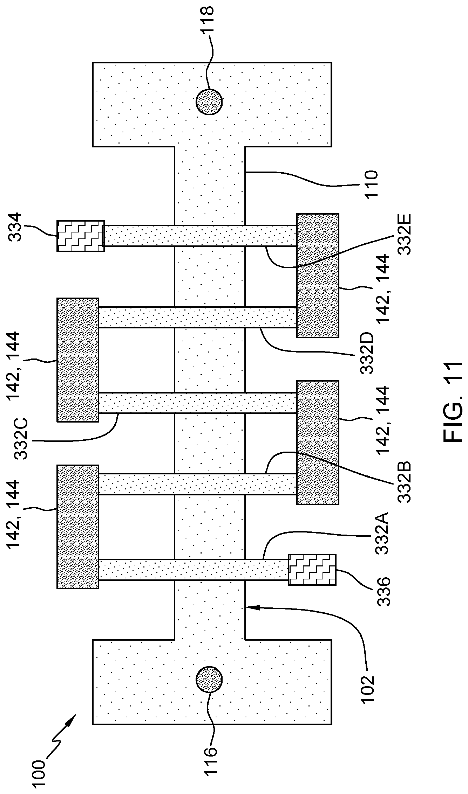

FIG. 10 and 11 show top-down views of fuse structure 100 according to another embodiment. FIGS. 10 and 11 are similar to FIGS. 8 and 9, except a metal wire 260 is not part of heat spreading structure 140, but part of metal heater 130. In this case, metal heater 130, as in FIGS. 1-3, includes a plurality of metal wires 332A-E extending over fuse body 102. Each metal wire 332A-E may couple to a least a portion of metal contacts 142 of heat spreading structure 140. While five metal wires 332A-E are shown arranged in a sinusoidal layout, any number of metal wires 332 may be used as part of metal heater 130, and may be coupled to any number of metal contacts 142 of heat spreading structure 140 to provide the desired heat transfer to fuse body 102.

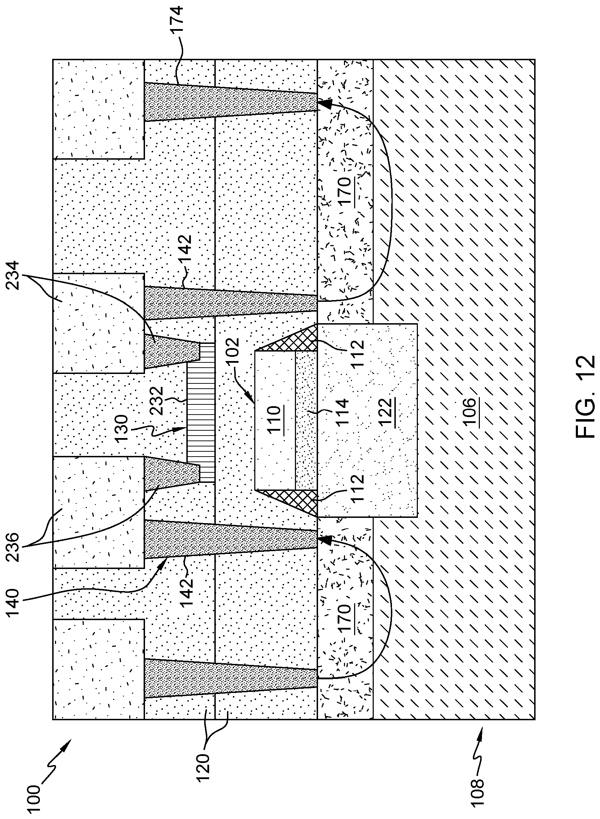

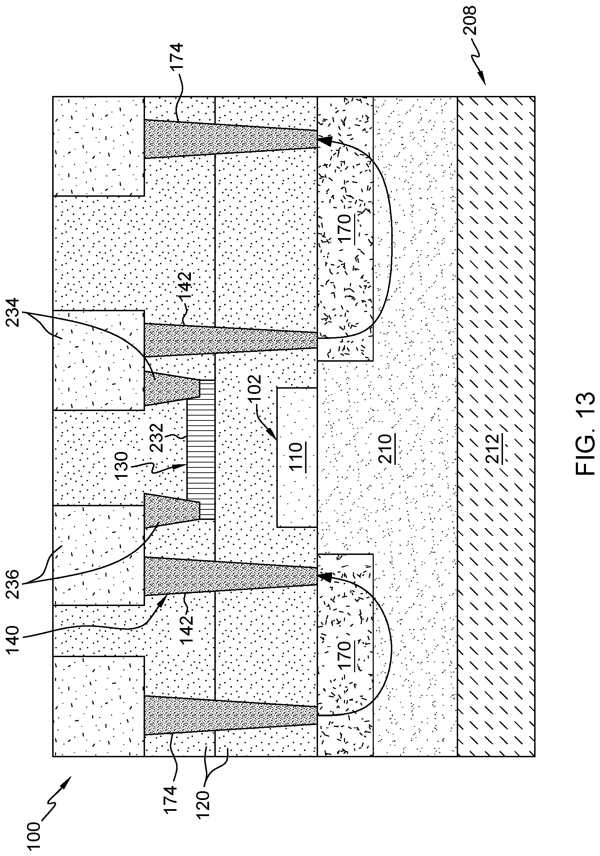

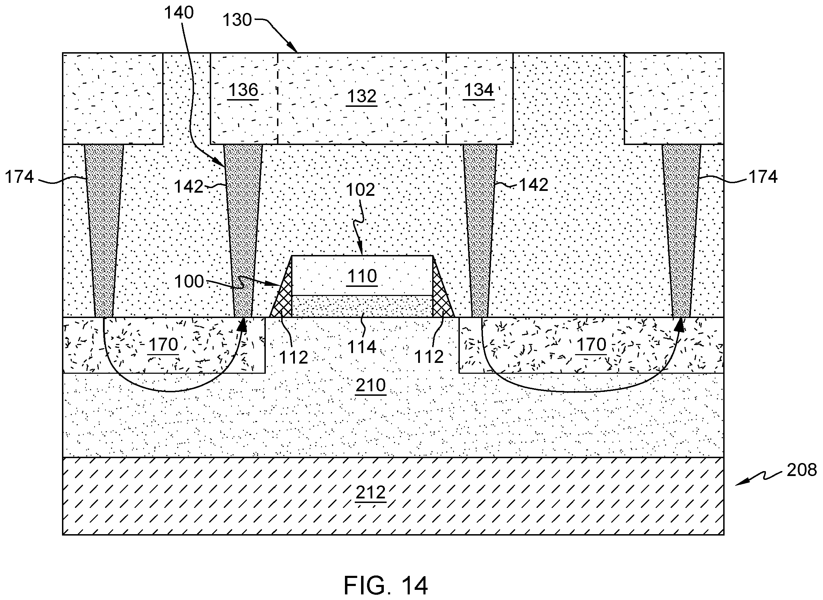

FIGS. 12-14 show Y cross-sectional views of fuse structure 100, according to embodiments not covered by the claims. In these embodiments, fuse structure 100 may include additional heating features in the form of a doped region 170 in substrate 108 below and to each side of fuse body 102 and a contact 174 landing on each doped region 170. Doped regions 170 are shown as n-type doped regions (n+), but they could be doped p-type depending on the type of transistors to be used elsewhere in IC structure 104. A portion of the plurality of metal contacts 142 land on each of the doped regions 170. FIG. 12 shows the additional heating features applied to the FIGS. 4-5 embodiment. FIG. 13 shows the additional heating feature applied to the FIGS. 4-5 embodiment, but including a semiconductor-on-insulator (SOI) substrate 208 application. SOI substrate 208 includes a semiconductor-on-insulator (SOI) layer (not shown) over a buried insulator layer 210 over a base semiconductor layer 212. FIG. 14 shows the additional heating features applied to the FIGS. 1-3 embodiment with an SOI substrate 208, like in FIG. 13.

In FIGS. 12-14, current can be directed through one doped region 170 (left side) using contact 174 (left side) to heat fuse body 102 from underneath and to the side using doped region 170 (left side). Current can then pass vertically upward through metal contacts 142 to metal heater 130, through metal heater 130 (resistor 232 in FIGS. 12-13, metal wire 132 in FIG. 14), and then vertically downward through metal contacts 142. Metal contacts 142 thus carry current and thermally communicate heat to fuse body 102 to/from metal heater 130. Current can pass from metal contacts 142 through the other doped region 170 (right side) to further heat fuse body 102 from underneath and to the side using doped region 170 (right side). Current can then pass out through contact 174 (right side). In this manner, the additional heating features of doped regions 170 can add more heat to fuse body 102.

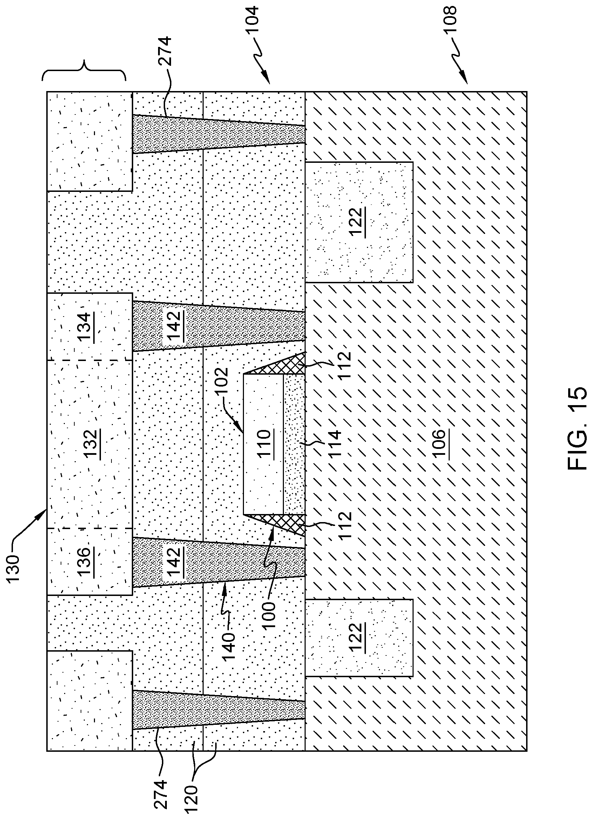

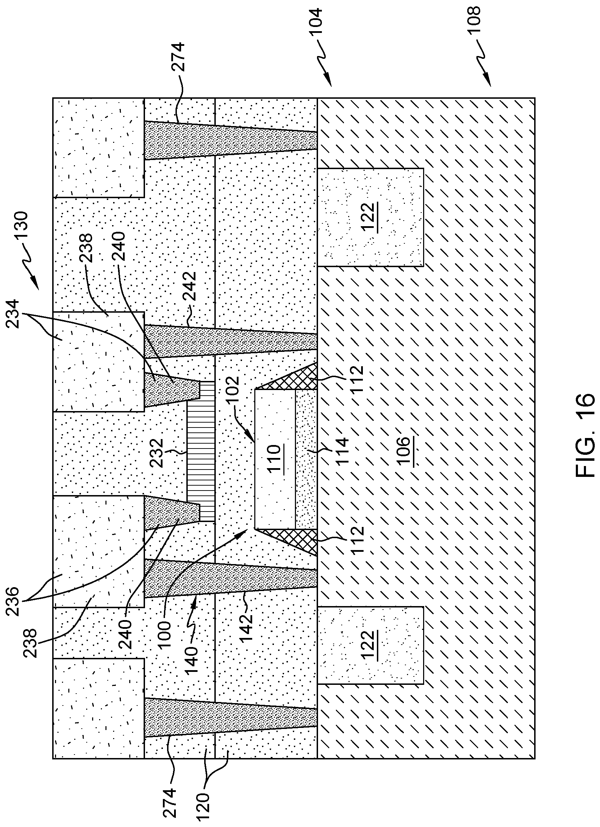

FIGS. 15-16 show Y cross-sectional views of fuse structure 100, according to other embodiments of the disclosure. FIGS. 15-16 show previous embodiments including additional heating features for heating fuse body 102. More particularly, fuse structure 100 may include additional heating features in the form of additional metal contacts 274 landing on active region 106 to the sides of fuse body 102. FIG. 15 shows the additional metal contacts 274 applied to the FIGS. 2-3 embodiments. FIG. 16 shows the additional metal contacts 274 applied to the FIGS. 4-5 embodiment. In FIGS. 15-16, current can be directed through one additional contact 274 (left side) to heat fuse body 102 from underneath and to the side using active region 106 (left side). Current can then pass vertically upward through metal contacts 142 to metal heater 130 (metal wire 132 in FIG. 15, resistor 232 in FIG. 16), through metal heater 130, and then vertically downward through metal contacts 142. Metal contacts 142 thus carry current and thermally communicate heat to fuse body 102 from metal heater 130. Current can pass from metal contacts 142 through active region 106 (right side) to further heat fuse body 102 from underneath and to the side using active region 106 (right side). Current can then pass out through metal contact 274 (right side). In this manner, the additional heating features are provided using active region 106 to add more heat to fuse body 102.

A method for heating a fuse in IC structure 104 according to embodiments of the disclosure may include heating an area over fuse body 102 using metal heater 130, and spreading heat from metal heater 130 through heat spreading structure 140 thermally coupled to metal heater 130 and extending horizontally adjacent to at least one side of fuse body 102.

Embodiments of the disclosure provide various technical and commercial advantages, examples of which are discussed herein. Embodiments of the disclosure provide a fuse structure that reduces the necessary programming energy and also reduces the size of a programming current source, which will reduce the overall circuitry footprint. As described, the fuse structure does not require any additional masks to implement.

The structure and method as described above are used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about", "approximately" and "substantially", are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The description of the present disclosure has been presented for purposes of illustration and description, but is not intended to be exhaustive or limited to the disclosure in the form disclosed. The embodiment was chosen and described in order to best explain the principles of the disclosure and the practical application, and to enable others of ordinary skill in the art to understand the disclosure for various embodiments with various modifications as are suited to the particular use contemplated.

At least in the embodiments above, the term "include" and its variants may be interpreted as meaning that an embodiment includes stated features, while not necessarily excluding the presence of other features that are not explicitly stated. The invention is defined by the appended claims.

## Claims

1. A fuse structure (100), comprising:
a fuse body (102) including a polysilicon;
a metal heater (130) on or over the fuse body (102);
a heat spreading structure (140) thermally coupled to the metal heater (130) and extending vertically to be horizontally adjacent to at least one side of the fuse body (102); and a first heater electrode (134) and a second heater electrode (136) coupled to respective opposite ends of the metal heater (130) and defining an electrical current path through the metal heater (130),
**characterised in that**
the heat spreading structure (140) includes a plurality of metal contacts (142) which is outside the electrical current path.

2. The fuse structure (100) of claim 1, wherein the plurality of metal contacts (142) is in thermal contact with the metal heater (130).

3. The fuse structure (100) of claim 1 or 2, wherein the plurality of metal contacts (142) each have one of a circular or bar cross-sectional shape in a top-down view.

4. The fuse structure (100) of one of claims 1 to 3, further comprising a doped region (170) in a substrate (108) below and to each side of the fuse body (102) and a contact (174) landing on each doped region (170), wherein a portion of the plurality of metal contacts (142) land on each of the doped regions (170).

5. The fuse structure (100) of one of claims 1 to 4, wherein the metal heater (130) includes at least a portion of a metal wire (132).

6. The fuse structure (100) of one of claims 1 to 4, wherein the metal heater (130) includes a resistor (232) including a resistive metal, and the heat spreading structure (140) includes a plurality of metal contacts (142) in thermal contact with the resistor (232).

7. The fuse structure (100) of claim 6, further comprising a metal wire (132) thermally coupling the plurality of metal contacts (142) together, the metal wire (132) preferably including a plurality of metal wires (132) extending over the fuse body (102), each of the metal wires (132) coupling to a least a portion of the plurality of metal contacts (142).

8. The fuse structure (100) of claim 7, wherein the resistor (232) is between the metal wire (132) and the fuse body (102) or the resistor (232) is over the metal wire (132).

9. The fuse structure (100) of one of claims 1 to 8, wherein:
the fuse body (102) is on a dielectric layer (114); and/or
the metal heater (130) laterally overlaps at least a portion of the fuse body (102).

10. The fuse structure (100) of one of claims 1 to 9, wherein the fuse body (102) includes a polysilicon body (110) having a pair of spacers (112) on opposing sides thereof, and the heat spreading structure (140) extends horizontally adjacent to the pair of spacers (112), the fuse structure (100) preferably further comprising a dielectric layer (114) between the polysilicon body (110) and the metal heater (130).

11. The fuse structure (100) of one of claims 1 to 10, further comprising a first fuse electrode (234) and a second fuse electrode (236) coupled to respective opposite ends of the fuse body (102).

12. The fuse structure (100) of one of claims 1 to 10, further comprising:
a first fuse electrode (234) and a second fuse electrode (236) coupled to respective opposite ends of the fuse body (102); and
heater electrodes (234, 236) coupled to respective opposite ends of the metal heater (130) and defining an electrical current path through the metal heater (130),
wherein the metal heater (130) laterally overlaps at least a portion of the fuse body (102), and
wherein the fuse body (102) is formed on a dielectric layer (114).

13. A method for heating a fuse in an integrated circuit structure (104), the fuse including the fuse structure (100) of one of claims 1 to 12, the method comprising:
heating an area over the fuse body (102) using a metal heater (130); and
spreading heat from the metal heater (130) through a heat spreading structure (140) thermally coupled to the metal heater (130) and extending horizontally adjacent to at least one side of the fuse body (102).

## Patentansprüche

1. Sicherungsstruktur (100), umfassend:
einen Sicherungskörper (102), der ein Polysilizium enthält;
ein Metallheizelement (130) auf oder über dem Sicherungskörper (102);
eine Wärmeverteilungsstruktur (140), die thermisch mit dem Metallheizelement (130) gekoppelt ist und sich vertikal erstreckt, um horizontal benachbart zu mindestens einer Seite des Sicherungskörpers (102) angeordnet zu sein; und
eine erste Heizelektrode (134) und eine zweite Heizelektrode (136), die mit jeweiligen gegenüberliegenden Enden des Metallheizelements (130) gekoppelt sind und einen elektrischen Strompfad durch das Metallheizelement (130) definieren,
**dadurch gekennzeichnet,**
**dass** die Wärmeverteilungsstruktur (140) eine Vielzahl von Metallkontakten (142) umfasst, die außerhalb des elektrischen Strompfads liegen.

2. Sicherungsstruktur (100) nach Anspruch 1, wobei die Vielzahl von Metallkontakten (142) in thermischem Kontakt mit dem Metallheizelement (130) steht.

3. Sicherungsstruktur (100) nach Anspruch 1 oder 2, wobei die Metallkontakte der Vielzahl von Metallkontakten (142) in einer Draufsicht jeweils entweder eine kreisförmige oder eine stabförmige Querschnittsform aufweisen.

4. Sicherungsstruktur (100) nach einem der Ansprüche 1 bis 3, ferner umfassend einen dotierten Bereich (170) in einem Substrat (108) unterhalb und auf jeder Seite des Sicherungskörpers (102) und einen Kontakt (174), der auf jedem dotierten Bereich (170) aufliegt, wobei ein Teil der Vielzahl von Metallkontakten (142) auf jedem der dotierten Bereiche (170) aufliegt.

5. Sicherungsstruktur (100) nach einem der Ansprüche 1 bis 4, wobei das Metallheizelement (130) wenigstens einen Abschnitt eines Metalldrahts (132) umfasst.

6. Sicherungsstruktur (100) nach einem der Ansprüche 1 bis 4, wobei das Metallheizelement (130) einen Widerstand (232) umfasst, der ein Widerstandsmetall umfasst, und die Wärmeverteilungsstruktur (140) eine Vielzahl von Metallkontakten (142) umfasst, die in thermischem Kontakt mit dem Widerstand (232) stehen.

7. Sicherungsstruktur (100) nach Anspruch 6, ferner umfassend einen Metalldraht (132), der die Vielzahl von Metallkontakten (142) thermisch miteinander koppelt, wobei der Metalldraht (132) vorzugsweise eine Vielzahl von Metalldrähten (132) umfasst, die sich über den Sicherungskörper (102) erstrecken, wobei jeder der Metalldrähte (132) mit wenigstens einem Teil der Vielzahl von Metallkontakten (142) gekoppelt ist.

8. Sicherungsstruktur (100) nach Anspruch 7, wobei der Widerstand (232) zwischen dem Metalldraht (132) und dem Sicherungskörper (102) angeordnet ist oder der Widerstand (232) über dem Metalldraht (132) angeordnet ist.

9. Sicherungsstruktur (100) nach einem der Ansprüche 1 bis 8, wobei:
der Sicherungskörper (102) auf einer dielektrischen Schicht (114) angeordnet ist; und/oder
das Metallheizelement (130) wenigstens einen Teil des Sicherungskörpers (102) lateral überlappt.

10. Sicherungsstruktur (100) nach einem der Ansprüche 1 bis 9, wobei der Sicherungskörper (102) einen Polysiliziumkörper (110) mit einem Paar Abstandshaltern (112) an dessen gegenüberliegenden Seiten umfasst und sich die Wärmeverteilungsstruktur (140) horizontal benachbart zu dem Paar Abstandshaltern (112) erstreckt, wobei die Sicherungsstruktur (100) vorzugsweise ferner eine dielektrische Schicht (114) zwischen dem Polysiliziumkörper (110) und dem Metallheizelement (130) umfasst.

11. Sicherungsstruktur (100) nach einem der Ansprüche 1 bis 10, ferner umfassend eine erste Sicherungselektrode (234) und eine zweite Sicherungselektrode (236), die mit jeweiligen gegenüberliegenden Enden des Sicherungskörpers (102) gekoppelt sind.

12. Sicherungsstruktur (100) nach einem der Ansprüche 1 bis 10, ferner umfassend:
eine erste Sicherungselektrode (234) und eine zweite Sicherungselektrode (236), die mit jeweiligen gegenüberliegenden Enden des Sicherungskörpers (102) gekoppelt sind; und
Heizelektroden (234, 236), die mit jeweiligen gegenüberliegenden Enden des Metallheizelements (130) gekoppelt sind und einen elektrischen Strompfad durch das Metallheizelement (130) definieren,
wobei das Metallheizelement (130) wenigstens einen Teil des Sicherungskörpers (102) lateral überlappt und
wobei der Sicherungskörper (102) auf einer dielektrischen Schicht (114) ausgebildet ist.

13. Verfahren zum Erwärmen einer Sicherung in einer integrierten Schaltungsstruktur (104), wobei die Sicherung die Sicherungsstruktur (100) nach einem der Ansprüche 1 bis 12 umfasst, wobei das Verfahren umfasst:
Erwärmen eines Bereichs über dem Sicherungskörper (102) unter Verwendung eines Metallheizelements (130); und
Verteilen von Wärme von dem Metallheizelement (130) durch eine Wärmeverteilungsstruktur (140), die thermisch mit dem Metallheizelement (130) gekoppelt ist und sich horizontal benachbart zu mindestens einer Seite des Sicherungskörpers (102) erstreckt.

## Revendications

1. Structure de fusible (100), comprenant :
un corps de fusible (102) incluant un silicium polycristallin ;
un élément chauffant métallique (130) au-dessus du corps de fusible (102) ou recouvrant celui-ci ;
une structure de diffusion de chaleur (140) couplée thermiquement à l'élément chauffant métallique (130) et s'étendant verticalement pour être horizontalement adjacente à au moins un côté du corps de fusible (102) ; et
une première électrode d'élément chauffant (134) et une deuxième électrode d'élément chauffant (136) couplées aux extrémités opposées respectives de l'élément chauffant métallique (130) et définissant un chemin de courant électrique à travers l'élément chauffant métallique (130),
**caractérisée en ce que** la structure de diffusion de chaleur (140) inclut une pluralité de contacts métalliques (142) qui se trouvent en dehors du chemin de courant électrique.

2. Structure de fusible (100) selon la revendication 1, dans laquelle la pluralité de contacts métalliques (142) est en contact thermique avec l'élément chauffant métallique (130).

3. Structure de fusible (100) selon la revendication 1 ou 2, dans laquelle les contacts de la pluralité de contacts métalliques (142) ont chacun une section transversale de forme circulaire ou en forme de barre dans une vue de dessus.

4. Structure de fusible (100) selon l'une des revendications 1 à 3, comprenant en outre une région dopée (170) dans un substrat (108) en dessous et de chaque côté du corps de fusible (102) et un contact (174) se posant sur chaque région dopée (170), dans laquelle une portion de la pluralité de contacts métalliques (142) se pose sur chacune des régions dopées (170).

5. Structure de fusible (100) selon l'une des revendications 1 à 4, dans laquelle l'élément chauffant métallique (130) inclut au moins une portion d'un fil métallique (132).

6. Structure de fusible (100) selon l'une des revendications 1 à 4, dans laquelle l'élément chauffant métallique (130) inclut une résistance (232) comprenant un métal résistif, et la structure de diffusion de chaleur (140) inclut une pluralité de contacts métalliques (142) en contact thermique avec la résistance (232).

7. Structure de fusible (100) selon la revendication 6, comprenant en outre un fil métallique (132) assurant le couplage thermique des contacts de la pluralité de contacts métalliques (142), le fil métallique (132) incluant de préférence une pluralité de fils métalliques (132) s'étendant sur le corps de fusible (102), chacun des fils métalliques (132) étant couplé à au moins une portion de la pluralité de contacts métalliques (142).

8. Structure de fusible (100) selon la revendication 7, dans laquelle la résistance (232) est agencée entre le fil métallique (132) et le corps de fusible (102), ou la résistance (232) est agencée sur le fil métallique (132).

9. Structure de fusible (100) selon l'une des revendications 1 à 8, dans laquelle :
le corps de fusible (102) est agencé sur une couche diélectrique (114) ; et/ou
l'élément chauffant métallique (130) chevauche latéralement au moins une portion du corps de fusible (102).

10. Structure de fusible (100) selon l'une des revendications 1 à 9, dans laquelle le corps de fusible (102) inclut un corps en silicium polycristallin (110) comportant une paire d'entretoises (112) sur ses côtés opposés, et la structure de diffusion de chaleur (140) s'étend horizontalement de manière adjacente à la paire d'entretoises (112), la structure de fusible (100) comprenant en outre de préférence une couche diélectrique (114) entre le corps en silicium polycristallin (110) et l'élément chauffant métallique (130).

11. Structure de fusible (100) selon l'une des revendications 1 à 10, comprenant en outre une première électrode de fusible (234) et une deuxième électrode de fusible (236) couplées aux extrémités opposées respectives du corps de fusible (102).

12. Structure de fusible (100) selon l'une des revendications 1 à 10, comprenant en outre :
une première électrode de fusible (234) et une deuxième électrode de fusible (236) couplées aux extrémités opposées respectives du corps de fusible (102) ; et
des électrodes d'élément chauffant (234, 236) couplées aux extrémités opposées respectives de l'élément chauffant métallique (130) et définissant un chemin de courant électrique à travers l'élément chauffant métallique (130),
dans laquelle l'élément chauffant métallique (130) chevauche latéralement au moins une portion du corps de fusible (102), et
dans laquelle le corps de fusible (102) est formé sur une couche diélectrique (114).

13. Procédé de chauffage d'un fusible dans une structure de circuit intégré (104), le fusible incluant la structure de fusible (100) selon l'une des revendications 1 à 12, le procédé comprenant :
le chauffage d'une zone située au-dessus du corps de fusible (102) en utilisant un élément chauffant métallique (130) ; et
la diffusion de la chaleur de l'élément chauffant métallique (130) via une structure de diffusion de chaleur (140) couplée thermiquement à l'élément chauffant métallique (130) et s'étendant horizontalement de manière adjacente à au moins un côté du corps de fusible (102).
